Europäisches Patentamt

European Patent Office

Office européen des brevets

(11) Publication number: **0 231 390 B1**

## EUROPEAN PATENT SPECIFICATION

(45) Date of publication of patent specification: **07.10.92**    (51) Int. Cl.5: **G01N 21/53**, G01N 21/59, G08B 17/10

(21) Application number: **86904400.8**

(22) Date of filing: **22.07.86**

(86) International application number:
**PCT/JP86/00387**

(87) International publication number:
**WO 87/00627 (29.01.87 87/03)**

(54) ASSEMBLY FOR MOUNTING LIGHT-EMITTING ELEMENT AND LIGHT-RECEIVING ELEMENT IN PHOTOELECTRIC SMOKE SENSOR.

(30) Priority: **22.07.85 JP 111990/85**

(43) Date of publication of application:
**12.08.87 Bulletin 87/33**

(45) Publication of the grant of the patent:
**07.10.92 Bulletin 92/41**

(84) Designated Contracting States:
**CH DE FR GB LI**

(56) References cited:
**EP-A- 0 075 304      JP-U- 5 452 284**
**JP-U-54 135 888      US-A- 3 985 453**
**US-A- 4 268 756      US-A- 4 584 485**

(73) Proprietor: **NOHMI BOSAI LTD.**
**7-3, Kudan Minami 4-chome**
**Chiyoda-ku Tokyo(JP)**

(72) Inventor: **OHWASI, Etuichi c/oNohmi Bosai**
**Kogyo Kabushiki Kai**
**sha/7-3, Kudan Minami 4-chome/Chiyoda-ku**
**Tokyo 102**
**/JP(JP)**

(74) Representative: **Jochem, Bernd,**
**Dipl.-Wirtsch.-Ing. et al**
**Patentanwälte Beyer & Jochem Postfach 17**
**01 45**
**W-6000 Frankfurt/Main(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### Technical Field

The present invention relates to a smoke detector comprising a light emitting element and a light receiving element mounted within a light tight box in fluid communication with the atmosphere on a base board by means of separate holders in such disposition that only when smoke enters into the light tight box scattered light of the light beam from the light emitting element reaches the light receiving element.

### Background Art

A photocell-typ smoke detector of the foregoing generall description is known from US-A-3,985,453. In this detector the light emitting element is snap-fitted into a holder which is screwed to a base plate. Similarly, a light receiving or detector element having an integral holder is fixed to the base plate by a screw.

Because the assembly of conventional detectors is troublesome and takes considerable time, it is the object of the present invention to provide a smoke detector of the above mentioned type which allows a simple and rapid mounting of the light emitting and light receiving elements and lenses to the base of the detector.

### Description of the invention

In order to attain the object, in accordance with the present invention a smoke detector is proposed in which each of said holders is received within a socket formed in the base board and has a substantially L-shaped cross-section comprising an upstanding, elastically deformable engaging member with a hook portion, which is inserted into the socket and by elastical engagement fixedly secures the holders thereto, and a supporting member extending at right angle to said engaging member and being formed with a hollow space for mounting said light emitting element and said light receiving element, respectively, and with a lens supporting portion formed at one of the open ends of said hollow space.

Alternatively the elastically deformable engaging member with the hook portion may be provided on the socket whereas the holder is formed with a stepped portion to engage said hook portion.

### Brief Description of the Drawings

Fig. 1 is a vertical sectional view of one embodiment of the present invention;
Fig. 2 is a vertical sectional view of the base shown in Fig. 1;
Fig. 3 is a side elevational view of the holder for the light emitting element;
Fig. 4 is a sectional view taken along the lines IV-IV in Fig. 3;
Fig. 5 is a side elevational view of the holder for the light receiving element shown in Fig. 1; and
Fig. 6 is a sectional view taken along the lines VI-VI in Fig. 5.

### Best Mode for Carrying Out the Invention

The present invention will be now explained in reference to the attached drawings wherein one embodiment of the present invention is shown.

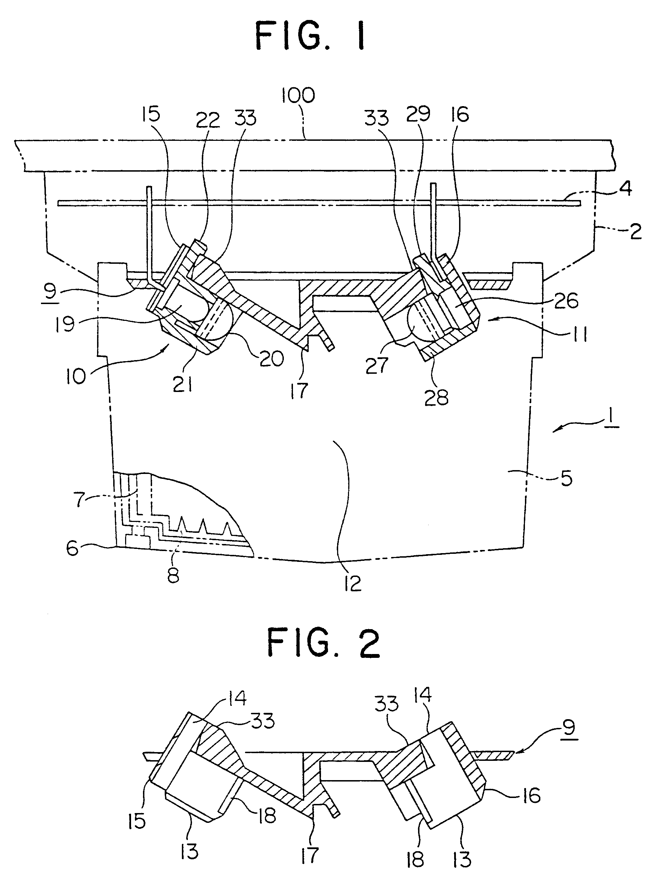

Referring now to Fig. 1 of the drawings wherein the reference numeral 1 indicates a photocell-type smoke detector embodying the present invention, it being illustrated here as a light-scattering type for example. Numeral 2 is a mold body containing a printed circuit board 4, with a light tight box 5 being mounted below the mold body 2. The light tight box 5 comprises a protective cover 6, an insect repellent net 7 and a labyrinth 8, with a base board 9 provided therein. Provided on the base board 9 are a light emitting part 10 and a light receiving part 11 with a smoke monitoring space 12 being left therebetween.

The base board 9 has, as shown in Figs. 1 and 2, a light emitting element socket 15 and a light receiving element socket 16, each comprising a holder receiving portion 13 and a portion 14 into which an engaging member is introduced. The sockets 15 and 16 are inclined relative to the base board 9, and this inclination angle is so selected that the optical axes of the light emitting and light receiving parts 10 and 12 intersect at a predetermined angle when the light emitting and light receiving parts 10 and 11 are mounted to the sockets 15 and 16, respectively. Numeral 17 is a light beam shield portion formed on the base board 9 between the sockets 15 and 16, and 18 is a holder guide portion formed at one of the open ends of the holder receiving portion 13 of the sockets 15 and 16.

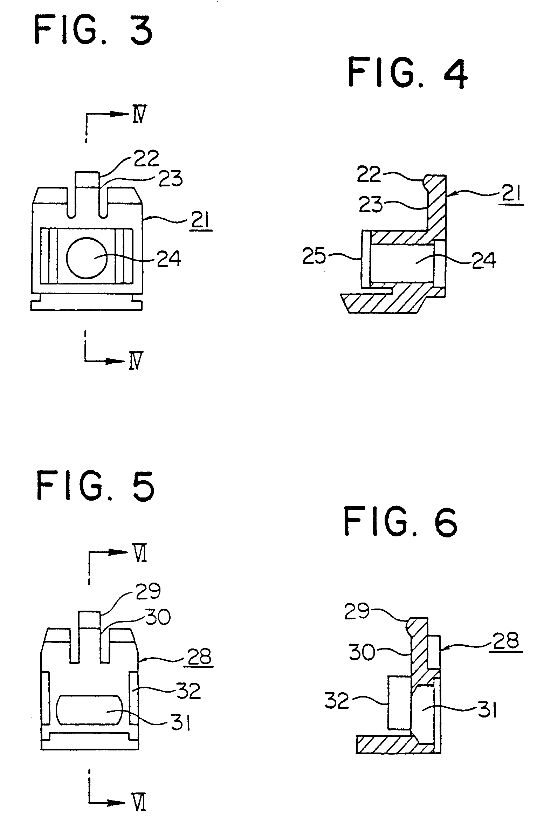

As shown in Fig. 1 the light emitting part 10 comprises a light emitting element 19, a lens 20 mounted in front of the light emitting element 19, and a holder 21 to receive them. The holder 21, as shown in Figs. 1, 3 and 4, has generally an L-shaped cross-section and comprises an upright engaging member 23, a supporting member with a hollow space 24 for the light emitting element 19 formed at right angles to the engaging member 23, and a lens support portion 25 provided at one of the open ends of the hollow space 24, whereby the engaging member 23 is made to be elastically deformable and formed at its end portion with a hook portion 22.

As shown in Fig. 1 the light receiving part 11 comprises a light receiving element 26, a lens 27, and a holder 28 to receive them. The holder 28 has, as shown in Figs. 1, 5 and 6, generally an L-shaped cross-section and comprises an upright engaging member 30, a supporting member with a hollow space 31 for the light receiving element 26 formed at right angles to the engaging member 30, and a lens support portion 32 provided at one of the open ends of the hollow space 31. The engaging member 30 is made to be elastically deformable, and is formed at its end portion with a hook portion 29. In Fig. 1 the reference numeral 100 denotes a ceiling to which the smoke detector is mounted.

The following is an explanation of the operation of the embodiment described so far.

First the light emitting element 19 is introduced into the hollow space 24 of the holder 21 for the light emitting part 10, and after the lens 20 is mounted in front of the light emitting element 19 by means of the lens support portion 25 the engaging member 23 of this holder 21 is introduced into the portion 14 of the socket 15 for the light emitting part 10 formed in the base board 9. Then the engaging member 23 elastically deforms, and upon completion of the introduction into the portion 14, the hook portion 22 elastically engages the stepped portion 33 of the socket 15, both being firmly secured together.

Similarly, the light receiving element 26 is introduced into the hollow space 31 of the holder 28 for the light receiving part 11, and the lens 27 is mounted in front of the light receiving element 26 by means of the lens support portion 32. Then the engaging member 30 of the holder 28 is introduced into the portion 14 of the socket 16 for the light receiving part 11 formed in the base board 9, whereby the hook portion 29 elastically engages the stepped portion 33 of the socket 15, both being securely fixed together.

It will be appreciated that the present invention is by no means limited to the embodiment explained above and illustrated. For example, instead of the elastically deformable hook portion being formed on the holder and the stepped portion to engage with the hook portion being formed on the socket the elastically deformable hook portion may be provided on the socket and the stepped portion to engage with the hook portion may be provided in the holder.

Since the assembly in accordance with the present invention has such a constitution and operation as stated above the holders are fixedly secured to the sockets only by inserting the former into the latter so that the light emitting and light receiving elements are firmly secured to the base board in position. Therefore, screw installation is not necessary as in the conventional smoke detector, allowing assembly in one process, and the operation is simplified and speedy, remarkably improving productivity.

## Claims

1. Smoke detector comprising a light emitting element (19) and a light receiving element (26) mounted within a light tight box (5) in fluid communication with the atmosphere on a base board (9) by means of separate holders (21, 28) in such disposition that only when smoke enters into the light tight box (5) scattered light of the light beam from the light emitting element (19) reaches the light receiving element (26), **characterized in that** each of said holders (21, 28) is received within a socket (15, 16) formed in the base board (9) and has a substantially L-shaped cross-section comprising an upstanding, elastically deformable engaging member (23, 30) with a hook portion (22, 29), which engaging member (23, 30) is inserted into the socket (15, 16) and by elastical engagement of said hook portion (22, 29) fixedly secures the holders (21, 28) thereto, and said holders (21, 28) have a supporting member extending at right angles to said engaging member (23, 30) and being formed with a hollow space (24, 31) for mounting said light emitting element (19) and said light receiving element (26), respectively, and with a lens supporting portion (25, 32) formed at one of the open ends of said hollow space (24, 31).

2. Smoke detector as claimed in claim 1, wherein said socket (15, 16) has a holder receiving portion (13), an inserting portion (14) for said engaging member (23, 30) and a stepped portion (33) to engage said hook portion (22, 29).

3. Smoke detector comprising a light emitting element (19) and a light receiving element (26) mounted within a light tight box (5) in fluid communication with the atmosphere on a base board (9) by means of separate holders (21, 28) in such disposition that only when smoke enters into the light tight box (5) scattered light of the light beam from the light emitting element (19) reaches the light receiving element (26), **characterized in that** each of said holders (21, 28) is received within a socket (15, 16) formed in the base board (9) said socket (15, 16) having an upstanding elastically deformable engaging member with a hook portion and said engaging member having a substantially L-shaped cross section, said holder comprising a stepped portion to engage said hook portion and a supporting member extending at right angles to said stepped portion and being formed with a hollow space (24, 31) for mounting said light emitting element (19) and said light receiving element (26), respectively, and with a lens supporting portion (25, 32) formed at one of the open ends of said hollow space (24, 31).

## Patentansprüche

1. Rauchdetektor mit einem lichtabstrahlenden Element (19) und einem lichtempfangenden Element (26), die beide in einem lichtdichten, in fluidischer Verbindung mit der Außenatmosphäre stehenden Gehäuse (5) mittels getrennter Halter (21, 28) in einer solchen Anordnung an einer Grundplatte (9) montiert sind, daß nur dann, wenn Rauch in das lichtdichte Gehäuse (5) eintritt, Streulicht des Lichtstrahls des lichtabstrahlenden Elements (19) das lichtempfangende Element (26) erreicht, **dadurch gekennzeichnet**, daß jeder der Halter (21, 28) in einer an der Grundplatte (9) angeformten Fassung (15, 16) aufgenommen ist und einen im wesentlichen L-förmigen Querschnitt hat mit einem abstehenden, elastisch verformbaren und mit einem Hakenteil (22, 29) versehenen Verbindungselement (23, 30), welches in die Fassung (15, 16) eingesteckt ist und durch elastischen Eingriff des Hakenteils (22, 29) die Halter (21, 28) daran befestigt, und daß die Halter (21, 28) jeweils ein Tragglied aufweisen, welches sich im rechten Winkel zum Verbindungsglied (23, 30) erstreckt und mit einem Hohlraum (24, 31) zum Einbau des lichtabstrahlenden Elements (19) bzw. des lichtempfangenden Elements (26) sowie mit einem eine Linse tragenden Teil (25, 32) ausgebildet ist, welcher an einem der offenen Enden des Hohlraums (24, 31) angeformt ist.

2. Rauchdetektor nach Anspruch 1, **dadurch gekennzeichnet**, daß die Fassung (15, 16) jeweils einen den Halter empfangenden Teil (13), einen Einführbereich (14) zum Zusammenwirken mit dem Verbindungsglied (23, 30) und einen abgesetzten Bereich (33) zum Eingriff des Hakenteils (22, 29) aufweist.

3. Rauchdetektor mit einem lichtabstrahlenden Element (19) und einem lichtempfangenden Element (26), die beide in einem lichtdichten, in fluidischer Verbindung mit der Außenatmosphäre stehenden Gehäuse (5) mittels getrennter Halter (21, 28) in einer solchen Anordnung an einer Grundplatte (9) montiert sind, daß nur dann, wenn Rauch in das lichtdichte Gehäuse (5) eintritt, Streulicht des Lichtstrahls des lichtabstrahlenden Elements (19) das lichtempfangende Element (26) erreicht, **dadurch gekennzeichnet**, daß jeder Halter (21, 28) in einer an der Grundplatte (9) angeformten Fassung (15, 16) aufgenommen ist, welche ein abstehendes, elastisch verformbares und mit einem Hakenteil versehenes Verbindungsglied mit einem im wesentlichen L-förmigen Querschnitt hat, und daß der Halter jeweils einen abgesetzten Bereich zum Eingriff des Hakenteils und ein Tragglied aufweist, welches sich im rechten Winkel zu dem abgesetzten Bereich erstreckt und mit einem Hohlraum (24, 31) zum Einbau des lichtabstrahlenden Elements (19) bzw. des lichtempfangenden Elements (26) sowie mit einem eine Linse tragenden Teil (25, 32) ausgebildet ist, welcher an einem der offenen Enden des Hohlraums (24, 31) angeformt ist.

## Revendications

1. Détecteur de fumée comprenant un élément émetteur de lumière (19) et un élément récepteur de lumière (26) montés à l'intérieur d'une boîte étanche à la lumière (5), en communication fluide avec l'atmosphère sur un panneau de base (9), au moyen de supports séparés (21, 28) dans une disposition telle, que la lumière dispersée du faisceau lumineux de l'élément émetteur de lumière (19) atteint l'élément récepteur de lumière (26) seulement lorsque de la fumée entre dans la boite étanche à la lumière (5), caractérisé en ce que chacun desdits supports (21, 28) est reçu dans une douille (15, 16) formée dans le panneau de base (9) et a en coupe sensiblement la forme d'un L comprenant un élément d'engagement dressé déformable élastiquement (23, 30) avec une portion en crochet (22, 29), lequel élément d'engagement (23, 30) est inséré dans la douille (15, 16) et y tient fermement les supports (21, 28) par l'engagement élastique de ladite portion en crochet (22, 29), et lesdits supports (21, 28) ont un élément de support s'étendant à angles droits par rapport audit élément d'engagement (23, 30) et étant formé avec un espace creux (24, 31) pour monter respectivement ledit élément émetteur de lumière (19) et ledit élément récepteur de lumière (26), et avec une portion de support de lentille (25, 32) formée à une des extrémités ouvertes dudit espace creux (24, 31).

2. Détecteur de fumée comme revendiqué dans la revendication 1, dans lequel ladite douille (15, 16) a une portion pour recevoir le support (13), une portion d'insertion (14) pour ledit élément d'engagement (23, 30) et une portion en gradin (33) pour s'engager avec ladite portion en crochet (22, 29).

3.  Détecteur de fumée comprenant un élément émetteur de lumière (19) et un élément récepteur de lumière (26) montés à l'intérieur d'une boîte étanche à la lumière (5), en communication fluide avec l'atmosphère sur un panneau de base (9) au moyen de supports séparés (21, 28) dans une disposition telle, que la lumière dispersée du faisceau lumineux de l'élément émetteur de lumière (19) atteint l'élément récepteur de lumière (26) seulement lorsque de la fumée entre dans la boîte étanche à la lumière (5), caractérisé en ce que chacun desdits supports (21, 28) est reçu dans une douille (15, 16) formée dans le panneau de base (9), ladite douille (15, 16) ayant un élément d'engagement dressé déformable élastiquement avec une portion en crochet et ledit élément d'engagement ayant en coupe sensiblement la forme d'un L, ledit support comprenant une portion en gradin pour s'engager avec ladite portion en crochet et un élément de support s'étendant à angles droits par rapport à ladite portion en gradin et étant formé avec un espace creux (24, 31) pour le montage respectivement dudit élément émetteur de lumière (19) et dudit élément récepteur de lumière (26), et avec une portion de support de lentille (25, 32) formée à l'une des extrémités ouvertes dudit espace creux (24, 31).

# FIG. 1

# FIG. 2

# FIG. 3

# FIG. 4

# FIG. 5

# FIG. 6